# EUROPÄISCHE PATENTANMELDUNG

(11) **EP 4 195 468 A1**
(43) Veröffentlichungstag der Anmeldung: **14.06.2023**
(21) Anmeldenummer: 21212852.4
(22) Anmeldetag: 07.12.2021
(51) Int. Cl.: H02K 11/02, H02K 11/01, H02K 11/40, H02K 23/66

(54) **ELEKTROMOTOR MIT ENTSTÖRVORRICHTUNG SOWIE VERFAHREN ZUR ANORDNUNG EINER ENTSTÖRVORRICHTUNG AN EINEM ELEKTROMOTOR**

(71) Anmelder: Dr. Fritz Faulhaber GmbH & Co. KG, 71101 Schönaich (DE)
(72) Erfinder: JACOBS, Florian, 72135 Dettenhausen (DE); SCHNEIDER, Thomas, 68723 Plankstadt (DE)
(74) Vertreter: Dr. Solf & Zapf Patent- und Rechtsanwalts PartG mbB

(57) **Zusammenfassung**

Die vorliegende Erfindung betrifft einen Elektromotor (1) mit einem Gehäuse (2), mindestens zwei Anschlusskontakten (3) und mindestens einer Entstörvorrichtung (4) gegen elektromagnetische Emissionen, wobei die Entstörvorrichtung (4) mindestens einen Schaltungsträger (5) mit mindestens einer Filterschaltung (6) aufweist, wobei der Schaltungsträger (5) an einer Endseite des Elektromotors (1) angeordnet ist, und wobei die Filterschaltung (6) elektrisch mit den beiden Anschlusskontakten (3) verbunden ist.

Der Aufwand für die Herstellung wird reduziert, indem an dem Schaltungsträger (5) mindestens ein elektrisch mit der Filterschaltung (6) verbundenes Kontaktmittel (7) befestigt ist, und dass das Kontaktmittel (7) unter zumindest teilweiser Verformung an einem Massekontakt (8) anliegt, so dass die Filterschaltung (6) über das Kontaktmittel (7) mit dem Massekontakt (8) elektrisch verbunden ist.

## Beschreibung

Die Erfindung betrifft einen Elektromotor, insbesondere einen mechanisch kommutierten Gleichstrommotor, mit einem Gehäuse, mindestens zwei Anschlusskontakten und mindestens einer Entstörvorrichtung gegen elektromagnetische Emissionen. Die Entstörvorrichtung weist mindestens einen Schaltungsträger auf, der an einer Endseite des Elektromotors angeordnet ist. Der Schaltungsträger weist mindestens eine Filterschaltung auf, die elektrisch mit den beiden Anschlusskontakten des Elektromotors verbunden ist.

Entstörvorrichtungen für Elektromotoren, insbesondere für Gleichstrommotoren, sind im Stand der Technik seit langem in einer Vielzahl von Ausgestaltungen bekannt. Bei mechanisch kommutierten Gleichstrommotoren ist die Hauptquelle für elektromagnetische Emissionen insbesondere das Bürstensystem aufgrund von Funkenbildung und Abheben der Bürsten bei Vibration. Ferner hat auch eine pulsweitenmodulierte Ansteuerung von Elektromotoren einen Einfluss auf die elektromagnetischen Emissionen.

Um elektromagnetische Emissionen eines Elektromotors zu reduzieren, ist es bekannt, einen Schaltungsträger mit einer Entstörschaltung elektrisch mit den Anschlusskontakten des Elektromotors sowie einem Massekontakt zu verbinden. Die Entstörvorrichtungen umfassen üblicherweise Kapazitäten und Induktivitäten, die zwischen den Anschlusskontakten in an sich bekannter Weise verschaltet werden. Idealerweise sind derartige Entstörschaltungen möglichst nah am Elektromotor selbst angeordnet.

Aus dem Stand der Technik ist es beispielweise bekannt, die Entstörvorrichtung mit dem Gehäuse zu verschweißen bzw. mit einer starren Verbindung elektrisch mit einem Eisenrückschluss des Elektromotors zu verbinden. Durch die Herstellung der mindestens einen Schweißverbindung, oftmals aber auch einer Mehrzahl von Schweißverbindungen, ist die Montagevorbereitung und damit der Montageaufwand insgesamt gesteigert.

Ausgehend von dem vorgenannten Stand der Technik liegt der vorliegenden Erfindung die Aufgabe zu Grunde, einen Elektromotor sowie ein Verfahren zur Anordnung einer Entstörvorrichtung an einem Elektromotor anzugeben, die die Herstellung vereinfachen.

Die vorgenannte Aufgabe ist bei einem gattungsgemäßen Elektromotor mit dem Merkmalsinhalt des Kennzeichnungsteils des Anspruchs 1 gelöst, nämlich dadurch, dass an dem Schaltungsträger mindestens ein elektrisch mit der Filterschaltung verbundenes Kontaktmittel befestigt ist, und dass das Kontaktmittel unter zumindest teilweiser Verformung an einem Massekontakt des Elektromotors anliegt, so dass die Filterschaltung über das Kontaktmittel mit dem Massekontakt elektrisch verbunden ist.

Bei dem Elektromotor handelt es sich vorzugsweise um einen mechanisch kommutierten Gleichstrommotor oder um einen bürstenlosen Gleichstrommotor oder einen anderen Elektromotor. Insbesondere ist vorgesehen, dass der Elektromotor mindestens einen Rotor, mindestens einen Stator und einen Eisenrückschluss aufweist. Die Anschlusskontakte versorgen den Elektromotor mit der erforderlichen Betriebsspannung. Im Falle eines mechanisch kommutierten Gleichstrommotors sind die Anschlusskontakte mit dem Kommutator, insbesondere den Bürsten, verbunden.

Der Schaltungsträger ist insbesondere an einer ersten Endseite des Elektromotors befestigt. Beispielsweise ist der Schaltungsträger als Leiterplatte, insbesondere als gedruckte Schaltung, oder als Tragelement aus einem nichtleitenden Material ausgebildet. Insbesondere wird der Schaltungsträger auf einem Bürstendeckel des Elektromotors angeordnet. Es ist vorzugsweise vorgesehen, eine Hochfrequenz-Abschirmung des Bürstenfeuers über einen Bürstendeckel, den Schaltungsträger, eine separate Scheibe und/oder eine metallisierte Beschichtung am Motordeckel zu realisieren.

Das Kontaktmittel ist vorzugsweise an einer in Richtung des Elektromotors orientierten Unterseite des Schaltungsträgers befestigt. Bei der Montage des Schaltungsträgers an dem Elektromotor wird das Kontaktmittel nach einem Kontakt mit dem Massekontakt verformt, so dass es möglichst großflächig an dem Massekontakt anliegt. Das Kontaktmittel wird vorzugsweise durch die Montage aus einer Ausgangsform verformt und/oder komprimiert und legt sich dabei insbesondere an den Massekontakt an. Insbesondere ist das Kontaktmittel zumindest teilweise elastisch verformt und/oder zumindest teilweise komprimiert. Das Kontaktmittel ist ausreichend flexibel, um eine Verformung bei der Montage zu gewährleisten, ohne den Montagevorgang zu verhindern. Im Montagezustand liegt das Kontaktmittel auf dem Massekontakt auf.

Aus der Verformung resultiert eine Kontaktkraft, mit der das Kontaktmittel an dem Massekontakt des Elektromotors anliegt und dadurch elektrisch mit diesem kontaktiert ist. Die Kontaktkraft resultiert im Wesentlichen aus der Kraft, die das Kontaktmittel der Verformung entgegensetzt.

Der Schaltungsträger wird an dem Elektromotor befestigt, beispielsweise indem der Schaltungsträger form- und/oder kraftschlüssig verrastet wird. Ferner ist vorgesehen, dass der Schaltungsträger an dem Elektromotor befestigt wird, indem die beiden Anschlusskontakte des Elektromotors mit zugeordneten Kontaktbereichen am Schaltungsträger verlötet werden. Die Lötverbindungen zwischen den Anschlusskontakten und den Kontaktflächen übernehmen gleichzeitig die mechanische Verbindung des Schaltungsträgers mit dem Elektromotor. Die Lötverbindungen übernehmen dann auch die aus der elastischen Verformung des Kontaktmittels resultierenden Gegenkräfte zur Kontaktkraft.

Die Filterschaltung weist vorzugsweise Kapazitäten in Form von Kondensatoren und/oder Induktivitäten in Form von Spulen auf. Vorzugsweise sind mindestens drei Kapazitäten und mindestens zwei Induktivitäten vorgesehen. Die Kapazitäten sind beispielsweise als mehrschichtige Keramikkondensatoren (MLCC), X2Y-Kondensatoren und/oder Durchführungskondensatoren ausgebildet. In Abhängigkeit von der Bauart weisen die Kondensatoren zwei oder mehr Anschlüsse auf. Die Induktivitäten sind in unterschiedlichen Bauformen, beispielsweise als Spulen ausgebildet oder als passives Design in einer Leiterbahn ausgeführt. In Abhängigkeit von der Ausgestaltung ist auch vorgesehen, dass Induktivitäten gekoppelt, z. B. als Gleichtaktdrossel, verwendet werden. Es ist auch vorgesehen, dass die Filterschaltung lediglich eine Mehrzahl von Kapazitäten aufweist. Die Induktivitäten sind folglich optional.

Die Verwendung eines verformbaren bzw. verformten Kontaktmittels hat gegenüber dem Stand der Technik den Vorteil, dass die Kontaktierung während der Montage automatisch erfolgt. Gleichzeitig gewährleistet die aus der Verformung resultierende Kontaktkraft ein Kontaktieren des Massekontakts auch bei Vibrationen oder ähnlichen mechanischen Einflüssen. Zudem kann der Schaltungsträger mit der Filterschaltung aufgrund des verformbaren Kontaktmittels sehr nah an dem Elektromotor angeordnet werden, wodurch die Filterung von elektromagnetischen Störungen verbessert wird.

Gemäß einer ersten vorteilhaften Ausgestaltung des Elektromotors ist vorgesehen, dass an dem Schaltungsträger mindestens zwei, insbesondere genau zwei, mindestens drei, insbesondere genau drei, oder mindestens vier, insbesondere genau vier, Kontaktmittel befestigt sind. Alle Kontaktmittel sind vorzugsweise identisch ausgebildet und erfüllen die gleiche Funktion. Jedes der zwei, drei oder vier Kontaktmittel ist mit jeweils einem Massekontakt oder einem gemeinsamen Massekontakt des Elektromotors elektrisch kontaktiert, indem jedes Kontaktmittel zumindest teilweise verformt an dem Massekontakt anliegt. Die vor- und nachstehenden Ausführungen zu einem einzelnen Kontaktmittel gelten gleichermaßen bei Vorhandensein von mehreren Kontaktmitteln für jedes Kontaktmittel.

Diese Ausgestaltung hat den Vorteil, dass durch die Mehrzahl an Kontakten eine Redundanz geschaffen wird, so dass stets die Kontaktierung zwischen einem jeweiligen Massekontakt und der Filterschaltung gewährleistet ist.

Gemäß einer weiteren Ausgestaltung des Elektromotors hat sich als vorteilhaft herausgestellt, wenn vorgesehen ist, dass der Massekontakt, an dem das mindestens eine Kontaktmittel anliegt, durch das Gehäuse und/oder einen Eisenrückschluss gebildet ist. Insbesondere ist der Massekontakt elektrisch leitend mit dem Eisenrückschluss verbunden. Das Kontaktmittel liegt verformt zumindest teilweise am Gehäuse und/oder zumindest teilweise am Eisenrückschluss an. Beispielsweise ist das Gehäuse elektrisch leitend mit dem Eisenrückschluss verbunden, so dass das gesamte Gehäuse als Massekontakt dient.

Als weiter vorteilhaft hat sich gemäß einer Ausgestaltung der Erfindung herausgestellt, wenn vorgesehen ist, dass das Gehäuse an mindestens einer Stelle eine, insbesondere konkave, Verformung aufweist, und dass das Kontaktmittel in der Verformung anliegt. Vorzugsweise ist die Verformung in einem in Richtung der Entstörvorrichtung orientierten Randbereich des Gehäuses ausgebildet. Durch die Anordnung des Kontaktmittels in der nach innen gerichteten Verformung des Gehäuses, also in einer im Wesentlichen konkaven Einwölbung des Gehäuses, ist gewährleistet, dass das Kontaktmittel nicht über die ursprüngliche Gehäusegeometrie hervorsteht. Besonders bevorzugt ist vorgesehen, dass die Verformung durch eine Verstemmung gebildet ist. Das Gehäuse ist beispielsweise mit einem Bürstendeckel und/oder mit dem Eisenrückschluss verstemmt. Beispielsweise ist vorgesehen, dass das Gehäuse an mindestens zwei, mindestens drei oder mindestens vier Stellen eine Verformung aufweist, und dass in jeder Verformung mindestens ein Kontaktmittel angeordnet ist. Bei jeder der Verformungen handelt es sich vorteilhaft um eine Verstemmung des Gehäuses.

Besonders vorteilhaft ist gemäß einer weiteren Ausgestaltung vorgesehen, dass das Kontaktmittel derart ausgebildet und angeordnet ist, dass es nicht über die Außenkontur des Gehäuses hinausragt. Das Kontaktmittel ist vorzugsweise derart ausgebildet und angeordnet, dass es sich trotz seiner eigenen Verformung und/oder Komprimierung, insbesondere in die Verformung des Gehäuses, derart einfügt, dass das Kontaktmittel nicht über die Außenkontur des Gehäuses hervorsteht, insbesondere nicht in radialer Richtung hervorsteht. Das wird beispielsweise durch eine gezielte Auswahl des Materials des Kontaktmittels unter Berücksichtigung der Ausgangsform des Kontaktmittels vor der Montage und der Verformbarkeit des Materials selbst, z. B. über die Komprimierbarkeit etc., gewährleistet.

Eine weitere Ausgestaltung des Elektromotors sieht vor, dass das Kontaktmittel bzw. die Kontaktmittel zumindest teilweise elastisch verformt und/oder zumindest teilweise komprimiert ist/sind. Das Kontaktmittel ist elastisch verformbar und/oder komprimierbar, insbesondere durch übliche Montagekräfte verformbar und/oder komprimierbar. Durch die elastische Verformung bzw. Komprimierung kann sich das Kontaktmittel möglichst vollflächig und/oder großflächig an den Massekontakt anlegen. Beispielsweise ist das Kontaktmittel zumindest teilweise aus einem elastischen und/oder kompressiblen, insbesondere strukturkompressiblen, Material hergestellt.

Als bevorzugte Materialien für das Kontaktmittel haben sich gemäß einer weiteren Ausgestaltung elektrisch leitfähig beschichtete, leitfähige oder nicht-leitfähige, Materialien oder elektrisch leitfähige Kunststoffe, insbesondere Elastomere, Silikone oder Gummi herausgestellt. Das elektrisch leitfähig beschichtete Material ist folglich selbst leitfähig, beispielsweise ein Metall, oder selbst nicht leitfähig, beispielsweise ein Kunststoff, ein Gummi oder ein Silikon. Besonders bevorzugt ist das Kontaktmittel aus einem elektrisch leitfähig beschichteten Elastomer hergestellt. Das Kontaktmittel, insbesondere ein als Elastomer ausgebildetes Kontaktmittel, weist vorzugsweise eine Komprimierbarkeit zwischen 10 % und 40 % der ursprünglichen Geometrie auf. Das Kontaktmittel, insbesondere ein als Elastomer ausgebildetes Kontaktmittel, hat vorzugsweise eine Härte von im Bereich zwischen 40 bis 75 Ufer A, insbesondere zwischen 50 und 60 Ufer A, vorzugsweise genau 50 oder 65 Ufer A, auf.

Das Kontaktmittel weist, insbesondere vor der Verformung zur Kontaktierung, vorzugsweise eine Breite auf, die etwa doppelt so groß ist wie jeweils die Höhe bzw. die Länge. Insbesondere ist vorgesehen, dass das Kontaktmittel mindestens eine, vorzugsweise zwei Ausnehmungen aufweist.

Die elektrisch leitfähige Beschichtung ist beispielsweise durch eine elektrisch leitfähige Folie, insbesondere aus einem Metall, oder eine Beschichtung mittels Chemical Vapor Deposition (CVD) oder Physical Vapor Deposition (PVD) hergestellt. Vorzugsweise beinhaltet die Beschichtung mindestens ein Metall, insbesondere Zinn, Silber, Gold und/oder Nickel. Ferner ist vorgesehen, dass die Beschichtung durch eine mit Zinn, Silber, Gold und/oder Nickel beschichtete Kupferfolie gebildet ist.

Beispielsweise ist vorgesehen, dass das Kontaktmittel als eine Kontaktfeder oder eine Kontaktbürste aus Metall hergestellt. Ferner ist vorgesehen, dass das Kontaktmittel einen elektrisch leitfähigen Kunststoff und/oder ein elektrisch leitfähiges Gummi und/oder ein elektrisch leitfähiges Silikon aufweist.

Durch die elastische Verformbarkeit und/oder Komprimierbarkeit des Kontaktmittels legt sich dieses mit einer Kontaktkraft an den Massekontakt an, wodurch eine vorteilhafte Kontaktierung des Massekontaktes für die Filterschaltung gewährleistet ist.

Um eine vorteilhafte Kontaktierung des Schaltungsträgers mit dem mindestens einen Massekontakt zu gewährleisten, ist gemäß einer weiteren Ausgestaltung vorgesehen, dass das Kontaktmittel in einem Randbereich des Schaltungsträgers angeordnet ist. Sind mehrere Kontaktmittel vorgesehen, sind die Kontaktmittel vorzugsweise gleichmäßig verteilt im Randbereich des Schaltungsträgers angeordnet. Insbesondere sind die Kontaktmittel unmittelbar an dem Rand des Schaltungsträgers angrenzend angeordnet.

Eine weitere Ausgestaltung des Elektromotors sieht vor, dass das Kontaktmittel bzw. die Kontaktmittel mit dem Schaltungsträger verklebt und/oder verlötet sind. Zur weiteren Vereinfachung der Montage hat es sich zudem als vorteilhaft herausgestellt, wenn vorgesehen ist, dass der Schaltungsträger in einem an dem Gehäuse befestigbaren Deckel angeordnet ist. Wird der Deckel an dem Gehäuse befestigt, wird gleichzeitig der Schaltungsträger derart an dem Elektromotor angeordnet bzw. festgelegt, dass das Kontaktmittel mit dem Massekontakt in Verbindung steht, indem es an dem Massekontakt anliegt. Die Entstörvorrichtung mit dem Schaltungsträger wird insbesondere durch den Deckel in der Montageposition, in der das Kontaktmittel an dem Massekontakt anliegt, gehalten.

Die eingangs genannte Aufgabe ist ferner gelöst durch ein Verfahren zur Anordnung einer Entstörvorrichtung gegen elektromagnetische Emissionen an einem Elektromotor, aufweisend mindestens die folgenden Verfahrensschritte:
- Bereitstellen eines Elektromotors mit mindestens zwei Anschlusskontakten,
- Bereitstellen einer Entstörvorrichtung mit mindestens einem Schaltungsträger mit einer Filterschaltung und mindestens einem Kontaktmittel,
- Verbringen der Entstörvorrichtung in ihre Montageposition am Elektromotor unter Verformung des Kontaktmittels und gleichzeitiger Kontaktierung eines Massekontaktes,
- Befestigen der Entstörvorrichtung in der Montageposition.

Die Kontaktierung des Kontaktmittels mit dem Massekontakt an dem Elektromotor erfolgt durch Annähern des Schaltungsträgers in die Montageposition und Befestigen des Schaltungsträgers in der Montageposition. Beim Annähern verformt sich das Kontaktmittel zumindest teilweise, insbesondere elastisch, und legt sich dadurch vorteilhaft an den Massekontakt an. Vorzugsweise verformt sich das Kontaktmittel derart, dass es beim Annähern zumindest teilweise komprimiert wird. Nachdem sich die Entstörvorrichtung in der Montageposition befindet, wird die Entstörvorrichtung am Elektromotor befestigt und das Kontaktmittel in seinem verformten Zustand gehalten.

Vorzugsweise ist der Elektromotor für das Verfahren gemäß einem der vorstehend beschriebenen Ausführungsbeispiele ausgebildet. Insbesondere weist der Schaltungsträger eine Mehrzahl an Kontaktmitteln auf. Vorzugsweise ist das Kontaktmittel bzw. sind die Kontaktmittel als mit einer leitfähigen Beschichtung versehenes Elastomer ausgebildet.

Das Befestigen der Entstörvorrichtung in der Montageposition kann auch indirekt dadurch erfolgen, dass ein Deckel, in dem die Entstörvorrichtung gehalten ist, an dem Elektromotor befestigt wird.

Die eingangs genannte Aufgabe ist ferner gelöst durch eine Verwendung eines verformbaren, insbesondere kompressiblen, elektrisch leitfähigen, an einem Schaltungsträger befestigten Kontaktmittels zur Kontaktierung einer Filterschaltung an einem Schaltungsträger mit mindestens einem Massekontakt eines Elektromotors. Vorzugsweise ist das Kontaktmittel als mit einer leitfähigen Beschichtung versehenes Elastomer ausgebildet. Das Kontaktmittel ist insbesondere durch die bei der Montage vorherrschenden Kräfte verformbar. Die Beschichtung umfasst beispielsweise eine zinn-, gold- und/oder nickelplattierte Kupferschicht oder Kupferfolie. Das Kontaktmittel ist insbesondere komprimierbar.

Weitere vorteilhafte Ausgestaltungen der Erfindung ergeben sich aus der folgenden Figurenbeschreibung und den abhängigen Unteransprüchen.

Es zeigen:
- Fig. 1: ein Ausführungsbeispiel eines Elektromotors mit Entstörvorrichtung in perspektivischer Ansicht,
- Fig. 2: einen Schnitt durch eine Vorrichtung gemäß Fig. 1 im Randbereich,
- Fig. 3: ein Ausführungsbeispiel eines Elektromotors in perspektivischer Ansicht,
- Fig. 4a: ein Ausführungsbeispiel einer Entstörvorrichtung in perspektivischer Ansicht von unten,
- Fig. 4b: das Ausführungsbeispiel der Fig. 4a von oben,
- Fig. 4c: das Ausführungsbeispiel der Fig. 4a und 4b in Seitenansicht,
- Fig. 5: ein Ausführungsbeispiel einer Filterschaltung als Schaltbild,
- Fig. 6: ein Ausführungsbeispiel eines Elektromotors während der Montage und
- Fig. 7: ein schematisches Ausführungsbeispiel eines Verfahrens zur Anordnung einer Entstörvorrichtung.

In den verschiedenen Figuren der Zeichnung sind gleiche Teile stets mit denselben Bezugszeichen versehen.

Zu der anschließenden Beschreibung wird beansprucht, dass die Erfindung nicht auf die Ausführungsbeispiele und dabei nicht auf alle oder mehrere Merkmale von beschriebenen Merkmalskombinationen beschränkt ist, vielmehr ist jedes einzelne Teilmerkmal des/jedes Ausführungsbeispiels auch losgelöst von allen anderen im Zusammenhang damit beschriebenen Teilmerkmalen für sich und auch in Kombination mit beliebigen Merkmalen eines anderen Ausführungsbeispiels von Bedeutung für den Gegenstand der Erfindung.

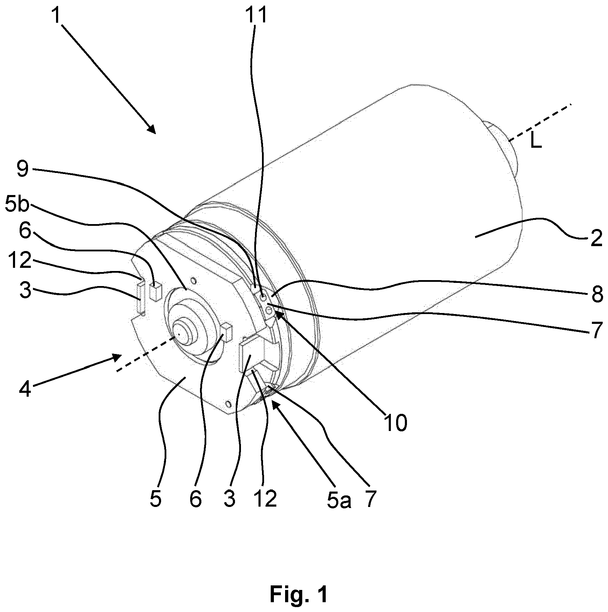

Fig. 1 zeigt ein Ausführungsbeispiel eines Elektromotors 1 in perspektivischer Ansicht. Der Elektromotor 1 weist ein Gehäuse 2 und zwei Anschlusskontakte 3 auf, mit denen bei diesem Ausführungsbeispiel die Bürsten kontaktiert sind. Das Gehäuse 2 ist aus einem elektrisch leitfähigen Metall hergestellt. Der Elektromotor 1 weist innerhalb des Gehäuses 2 die üblichen Komponenten eines Elektromotors 1, nämlich mindestens einen Rotor, mindestens einen Stator sowie bei diesem Ausführungsbeispiel mindestens einen Kommutator auf.

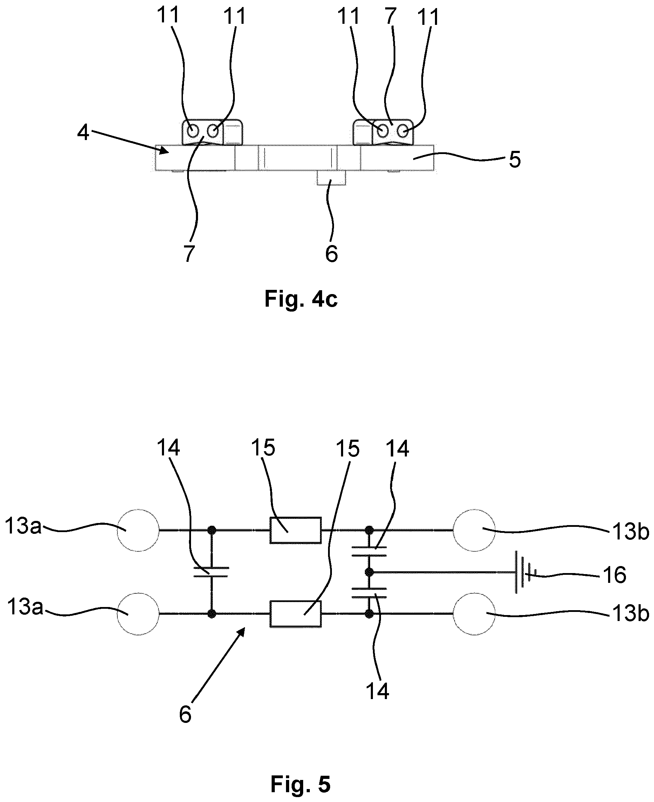

An dem Gehäuse 2 des Elektromotors 1 ist eine Entstörvorrichtung 4 angeordnet, die einen Schaltungsträger 5 mit daran angeordneter Filterschaltung 6 aufweist. Die Filterschaltung 6 ist elektrisch mit den Anschlusskontakten 3 verbunden. An dem Schaltungsträger 5 sind ferner vier Kontaktmittel 7 befestigt und elektrisch mit der Filterschaltung 6 verbunden. Die Filterschaltung 6 weist leitende Verbindungen zwischen den Komponenten der Filterschaltung 6 auf, die in Fig. 1 nicht separat dargestellt sind. Eine beispielhafte Filterschaltung 6 ist in Fig. 5 dargestellt.

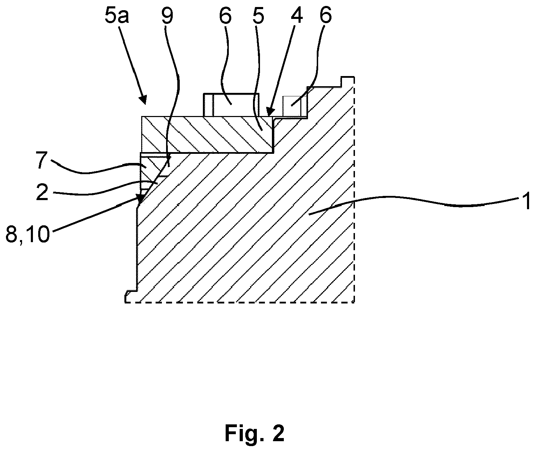

Gemäß Fig. 1 sind die Kontaktmittel 7 zumindest teilweise verformt und liegen an einem Massekontakt 8 an, der bei diesem Ausführungsbeispiel zumindest teilweise durch das Gehäuse 2 gebildet wird. Das Gehäuse 2 ist elektrisch mit dem Eisenrückschluss verbunden. Fig. 2 zeigt einen Schnitt durch eines der Kontaktmittel 7 gemäß Fig. 1. Das Kontaktmittel 7 ist im Bereich der Verformung 10 des Gehäuses 2 verformt und liegt vollflächig in der Verformung 10 an dem Gehäuse 2 und dem Bürstendeckel 9 an. Das Kontaktmittel 7 ist gemäß Fig. 2 zumindest teilweise komprimiert und geht nicht über die Kontur des Gehäuses 2, insbesondere nicht in radialer Richtung, hinaus.

Die Kontaktmittel 7 sind gemäß Fig. 1 im Randbereich 5a des Schaltungsträgers 5 angeordnet und gleichmäßig beabstandet zueinander auf dem Schaltungsträger 5 verteilt. Das Gehäuse 2 weist vier konkave Verformungen 10 auf, die bei diesem Ausführungsbeispiel durch eine Verstemmung des Gehäuses 2 mit dem Bürstendeckel 9 gebildet sind. Jedes der Kontaktmittel 7 ist in einer der Verformungen 10 angeordnet. Die Kontaktmittel 7 sind derart ausgebildet und angeordnet, dass sie derart innerhalb der Verformungen 10 angeordnet sind, dass sie nicht über die Außenkontur des Gehäuses 2, insbesondere nicht in radialer Richtung, vor der Verformung hinausragen.

Die Kontaktmittel 7 sind bei diesem Ausführungsbeispiel als Elastomer ausgebildet, das mit einer Beschichtung aus mindestens einem Metall versehen ist. Das elastisch verformbare und kompressible Elastomer legt sich vorteilhaft in die Verformung 10 an, so dass eine große Kontaktfläche am Massekontakt 8 erzielt wird.

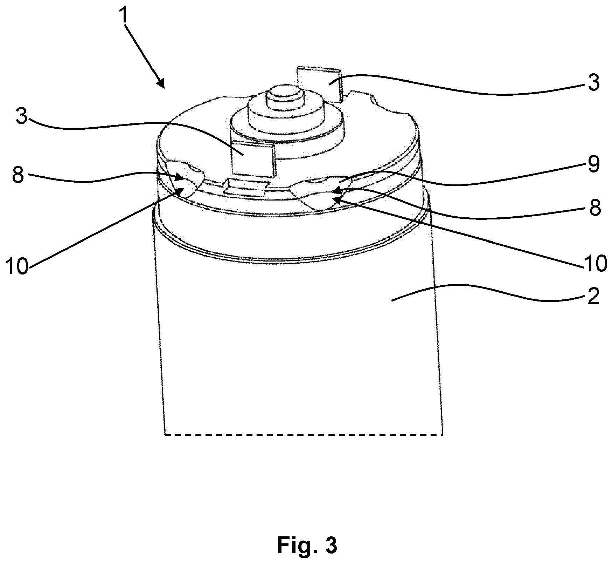

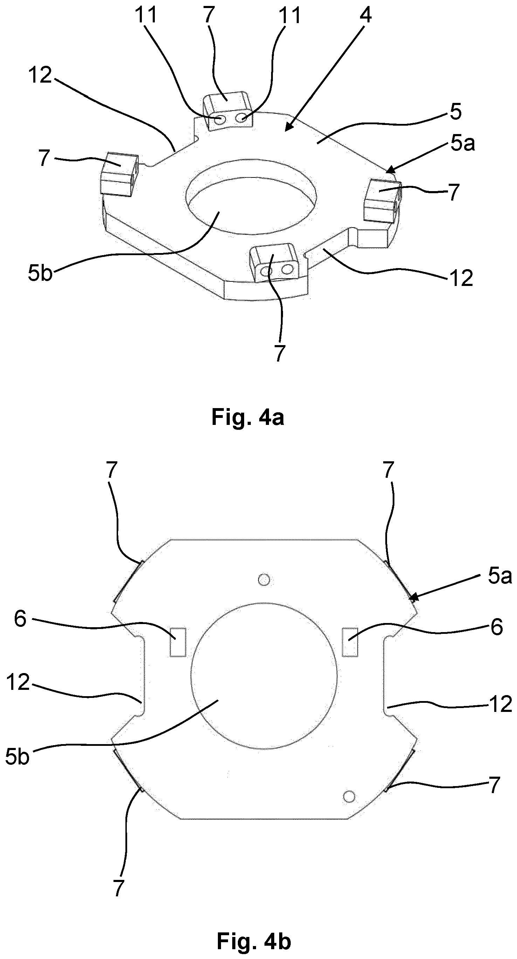

Fig. 3 zeigt ein Ausführungsbeispiel eines Elektromotors 1 in perspektivischer Ansicht. An dem Motor 1 ist noch keine Entstörvorrichtung 4, beispielsweise gemäß Fig. 4a bis 4c, montiert. Das Gehäuse 2 des Motors 1 ist im Bereich von vier über den Umfang angeordneten, konkaven Verformungen 10 mit dem Bürstendeckel 9 des Elektromotors 1 verstemmt. Das Gehäuse 2 ist in Richtung des Bürstendeckels 9 verformt, um formschlüssig mit diesem zusammenzuwirken. In diese Verformungen 10 kann nach der Montage der Entstörvorrichtung 4 jeweils ein Kontaktmittel 7 eingreifen und das Gehäuse 2 als Massekontakt 8 kontaktieren. Die Anschlusskontakte 3 des Elektromotors 1 treten im Wesentlichen senkrecht aus dem Elektromotor 1 hervor.

Eine Entstörvorrichtung 4, die auf einen Elektromotor 1 gemäß Fig. 3 montierbar ist, ist beispielhaft in den Fig. 4a bis 4c dargestellt. Fig. 4a zeigt die Entstörvorrichtung 4 in einer perspektivischen Ansicht von unten. An dem Schaltungsträger 5 der Entstörvorrichtung 4 sind gleichmäßig beabstandet zueinander vier Kontaktmittel 7 angeordnet und mit dem Schaltungsträger 5 derart leitfähig verlötet, dass die Kontaktmittel 7 elektrisch mit der Filterschaltung 6 verbunden sind. Die die Komponenten der Filterschaltung 6 verbindenden Leitungspfade sind in den Fig. 4a bis 4c nicht dargestellt. Die Kontaktmittel 7 weisen gemäß Fig. 4a bis 4c vor der Verformung während der Montage eine im Wesentlichen rechteckige Form auf, wobei die Breite etwa doppelt so groß ist wie die Länge und die Höhe. Jedes Kontaktmittel 7 weist ein oder zwei zentrale Ausnehmungen 11 auf, die das Kontaktmittel 7 in Längenrichtung durchtreten. Die Kontaktmittel 7 sind aus einem Elastomer hergestellt und weisen auf ihrer Oberfläche eine elektrisch leitfähige Beschichtung auf. Die Kontaktmittel 7 sind elastisch verformbar sowie kompressibel.

Die Anschlusskontakte 3 gemäß Fig. 1 und Fig. 3 sind in Aufnahmebereichen 12 des Schaltungsträgers 5 gemäß Fig. 4a bis Fig. 4c mit dem Schaltungsträger 5 verlötbar, so dass eine elektrische Kontaktierung der Filterschaltung 6 realisiert wird, wodurch die Filterschaltung 6 zwischen den Anschlusskontakten 3, beispielsweise wie gemäß Fig. 5, elektrisch verschaltet ist. Der Schaltungsträger 5 weist eine zentrale Ausnehmung 5b auf, durch die die Komponenten des Elektromotors in der Montageposition - siehe Fig. 1 - hindurchtreten können.

Fig. 5 zeigt ein Ausführungsbeispiel einer Filterschaltung 6 als Schaltbild. Die Filterschaltung 6 ist über Anschlussbereiche 13a und 13b mit den Anschlusskontakten 3 des Elektromotors 1 verbindbar. Die Filterschaltung 6 umfasst drei Kapazitäten 14 und zwei Induktivitäten 15. Zwischen zwei Kapazitäten 14 ist der Masseanschluss 16 vorgesehen, der über die Kontaktmittel 7 (siehe beispielsweise Fig. 1) mit einem Massekontakt 8 - gemäß Fig. 1 das Gehäuse 2 und der Eisenrückschluss 9 - des Elektromotors 1 verbunden wird. Die Induktivitäten 15 sind zwischen den Anschlussbereichen 13a, 13b in Reihe geschaltet angeordnet, die Kapazitäten 14 sind zwischen den Anschlusskontakten 13a, 13b parallelgeschaltet angeordnet.

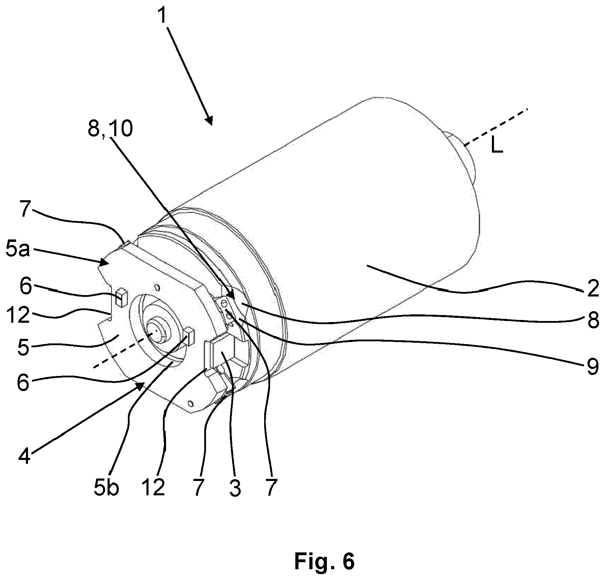

Fig. 6 zeigt ein Ausführungsbeispiel eines Elektromotors 1 während der Montage. Die Entstörvorrichtung 4 wird in einer Richtung entlang der Längsachse L auf eine Endseite des Elektromotors 1 zu bewegt, so dass die Anschlusskontakte 3 in die Aufnahmebereiche 12 eingreifen und die Kontaktmittel 7 in den Verformungen 10 mit einer möglichst großen Kontaktfläche zur Anlage kommen. In Fig. 6 sind die Kontaktmittel 7 noch nicht verformt bzw. komprimiert und verformen sich, beispielsweise gemäß Fig. 2, wenn sich der Schaltungsträger 5 in seiner Montageposition (siehe Fig. 1 und Fig. 2) befindet. Bei diesem Ausführungsbeispiel wird der Schaltungsträger 5 an dem Elektromotor 1 dadurch befestigt, dass die Anschlusskontakte 3 in den Aufnahmebereichen 12 verlötet werden.

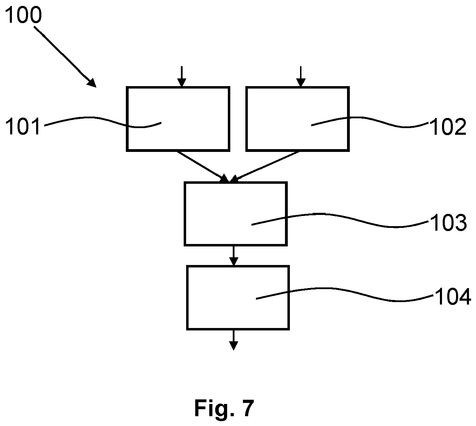

Fig. 7 zeigt den schematischen Ablauf eines Ausführungsbeispiels eines Verfahrens 100 zur Anordnung einer Entstörvorrichtung 4 gegen elektromagnetische Emissionen an einem Elektromotor 1. Zunächst erfolgt das Bereitstellen 101 eines Elektromotors 1 mit mindestens zwei Anschlusskontakten 3, insbesondere gemäß einem der vorstehend beschriebenen Ausführungsbeispiele. Ferner erfolgt das Bereitstellen 102 einer Entstörvorrichtung 4 mit mindestens einem Schaltungsträger 5 und einer Filterschaltung 6, beispielsweise gemäß Fig. 5, sowie mindestens einem Kontaktmittel 7. Nachfolgend erfolgt das Verbringen 103 der Entstörvorrichtung 4 in ihre Montageposition (beispielsweise gemäß Fig. 1) am Elektromotor 1 unter elastischer Verformung des Kontaktmittels 7 bzw. der Kontaktmittel 7 bei gleichzeitiger Kontaktierung des Kontaktmittels 7 bzw. der Kontaktmittel 7 mit einem Massekontakt 8, hier beispielsweise dem Gehäuse 2. Abschließend erfolgt das Befestigen 104 der Entstörvorrichtung 4 an dem Elektromotor 1, beispielsweise indem die Anschlusskontakte 2 in den Aufnahmebereichen 12 verlötet werden.

Die Erfindung ist nicht auf die dargestellten und beschriebenen Ausführungsbeispiele beschränkt, sondern umfasst auch alle im Sinne der Erfindung gleichwirkenden Ausführungen. Es wird ausdrücklich betont, dass die Ausführungsbeispiele nicht auf alle Merkmale in Kombination beschränkt sind, vielmehr kann jedes einzelne Teilmerkmal auch losgelöst von allen anderen Teilmerkmalen für sich eine erfinderische Bedeutung haben. Ferner ist die Erfindung bislang auch noch nicht auf die im Anspruch 1 definierte Merkmalskombination beschränkt, sondern kann auch durch jede beliebige andere Kombination von bestimmten Merkmalen aller insgesamt offenbarten Einzelmerkmale definiert sein. Dies bedeutet, dass grundsätzlich praktisch jedes Einzelmerkmal des Anspruchs 1 weggelassen beziehungsweise durch mindestens ein an anderer Stelle der Anmeldung offenbartes Einzelmerkmal ersetzt werden kann.

### Bezugszeichenliste

- 1: Elektromotor
- 2: Gehäuse
- 3: Anschlusskontakte
- 4: Entstörvorrichtung
- 5: Schaltungsträger
- 5a: Randbereich
- 5b: Ausnehmung
- 6: Filterschaltung
- 7: Kontaktmittel
- 8: Massekontakt
- 9: Bürstendeckel
- 10: Verformung
- 11: Ausnehmungen
- 12: Aufnahmebereiche
- 13a: Anschlussbereiche
- 13b: Anschlussbereiche
- 14: Kapazitäten
- 15: Induktivitäten
- 16: Masseanschluss
- 100: Verfahren
- 101: Bereitstellen des Elektromotors 1
- 102: Bereitstellen der Entstörvorrichtung 4
- 103: Verbringen der Entstörvorrichtung 4 in die Montageposition
- 104: Verbinden
- L: Längsachse

## Patentansprüche

1. Elektromotor (1) mit einem Gehäuse (2), mindestens zwei Anschlusskontakten (3) und mindestens einer Entstörvorrichtung (4) gegen elektromagnetische Emissionen, wobei die Entstörvorrichtung (4) mindestens einen Schaltungsträger (5) mit mindestens einer Filterschaltung (6) aufweist, wobei der Schaltungsträger (5) an einer Endseite des Elektromotors (1) angeordnet ist, und wobei die Filterschaltung (6) elektrisch mit den beiden Anschlusskontakten (3) verbunden ist,
**dadurch gekennzeichnet, dass**
an dem Schaltungsträger (5) mindestens ein elektrisch mit der Filterschaltung (6) verbundenes Kontaktmittel (7) befestigt ist, und dass das Kontaktmittel (7) unter zumindest teilweiser Verformung an einem Massekontakt (8) anliegt, so dass die Filterschaltung (6) über das Kontaktmittel (7) mit dem Massekontakt (8) elektrisch verbunden ist.

2. Elektromotor (1) nach Anspruch 1,
**dadurch gekennzeichnet, dass**
mindestens zwei, mindestens drei oder mindestens vier Kontaktmittel (7) an dem Schaltungsträger (5) befestigt sind.

3. Elektromotor (1) nach Anspruch 1 oder 2,
**dadurch gekennzeichnet, dass**
der Massekontakt (8) durch das Gehäuse (2) und/oder zumindest mittelbar oder unmittelbar durch einen Eisenrückschluss des Elektromotors (1) gebildet ist, und dass das Kontaktmittel (7) zumindest teilweise am Gehäuse (2) und/oder zumindest mittelbar oder unmittelbar am Eisenrückschluss anliegt.

4. Elektromotor (1) nach einem der Ansprüche 1 bis 3,
**dadurch gekennzeichnet, dass**
das Gehäuse (2) mindestens eine Verformung (10), insbesondere an einem in Richtung der Entstörvorrichtung (4) orientierten Randbereich, aufweist, und dass das Kontaktmittel (7) in der Verformung (10) anliegt, vorzugsweise dass die Verformung (10) durch eine Verstemmung gebildet ist.

5. Elektromotor (1) nach einem der Ansprüche 1 bis 4,
**dadurch gekennzeichnet, dass**
das Kontaktmittel (7) derart ausgebildet und angeordnet ist, dass es nicht über die Außenkontur des Gehäuses (2) hinausragt.

6. Elektromotor (1) nach einem der Ansprüche 1 bis 5,
**dadurch gekennzeichnet, dass**
das Kontaktmittel (7) zumindest teilweise elastisch verformt und/oder zumindest teilweise komprimiert ist.

7. Elektromotor (1) nach einem der Ansprüche 1 bis 6,
**dadurch gekennzeichnet, dass**
das Kontaktmittel (7) aus einem elektrisch leitfähig beschichteten, leitfähigen oder nicht-leitfähigen, Material oder einem elektrisch leitfähigen Kunststoff, Silikon oder Gummi hergestellt ist.

8. Elektromotor (1) nach einem der Ansprüche 1 bis 7,
**dadurch gekennzeichnet, dass**
das Kontaktmittel (7) in einem Randbereich des Schaltungsträgers (5) angeordnet ist.

9. Elektromotor (1) nach einem der Ansprüche 1 bis 8,
**dadurch gekennzeichnet, dass**
das Kontaktmittel (7) mit dem Schaltungsträger (5) verklebt und/oder verlötet ist.

10. Elektromotor (1) nach einem der Ansprüche 1 bis 9,
**dadurch gekennzeichnet, dass**
der Schaltungsträger (5) in einem das Gehäuse (2) begrenzenden Deckel angeordnet ist.

11. Verfahren (100) zur Anordnung einer Entstörvorrichtung (4) gegen elektromagnetische Emissionen an einem Elektromotor (1), insbesondere nach einem der Ansprüche 1 bis 10, aufweisend mindestens die folgenden Verfahrensschritte:
- Bereitstellen (101) eines Elektromotors (1) mit mindestens zwei Anschlusskontakten (3),
- Bereitstellen (102) einer Entstörvorrichtung (4) mit mindestens einem Schaltungsträger (5) mit einer Filterschaltung (6) und mindestens einem Kontaktmittel (7),
- Verbringen (103) der Entstörvorrichtung (4) in ihre Montageposition am Elektromotor (1) unter Verformung des Kontaktmittels (7) und gleichzeitiger Kontaktierung eines Massekontaktes (8),
- Befestigen der Entstörvorrichtung (4) in der Montageposition.

12. Verwendung eines verformbaren, insbesondere kompressiblen, elektrisch leitfähig beschichteten, an einem Schaltungsträger befestigten Kontaktmittels (7) zur Kontaktierung einer Filterschaltung (6) an dem Schaltungsträger (5) mit mindestens einem Massekontakt (8) eines Elektromotors (1).
